# DEMANDE DE BREVET EUROPEEN

(11) **EP 1 156 533 A1**
(43) Date de publication de la demande: **21.11.2001**
(21) Numéro de dépôt: 01410055.6
(22) Date de dépôt: 16.05.2001
(51) Int. Cl.: H01L 29/06, H01L 29/417, H01L 23/31

(54) **Structure périphérique de composant vertical**

(30) Priorité: 17.05.2000 FR 0006300
(71) Demandeur: STMicroelectronics S.A., 92120 Montrouge (FR)
(72) Inventeur: Roy, Mathieu, 37300 Joue les Tours (FR)
(74) Mandataire: de Beaumont, Michel

(57) **Abrégé**

L'invention concerne un composant de puissance formé dans un substrat (1) de silicium de type N dont les faces inférieure et supérieure comprennent respectivement une première (3) et une deuxième (4) région de type P ne s'étendant pas jusqu'à la périphérie du composant, une tension élevée étant susceptible d'exister entre les première et deuxième régions et devant être supportée par les jonctions entre les première et deuxième régions et le substrat. Dans la périphérie inférieure du composant est formée une région isolante profonde (31) ne rejoignant pas la première région (3), la surface inférieure du substrat entre ladite région isolante profonde étant revêtue d'une couche isolante (13), la hauteur de la région isolante profonde étant supérieure à celle d'une éventuelle remontée de brasure (22) lors de la brasure de la face inférieure sur un répartiteur thermique.

## Description

La présente invention concerne les composants de puissance et plus particulièrement une optimisation de la tenue en tension de composants de puissance de type vertical dont la face arrière est susceptible d'être brasée sur un répartiteur thermique.

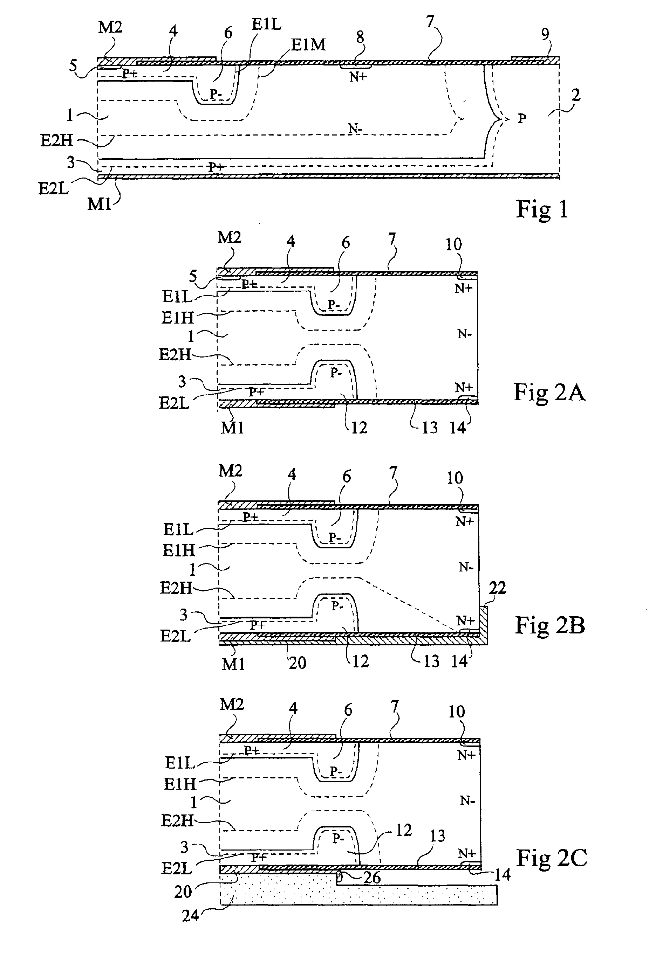

La figure 1 représente de façon très schématique une vue en coupe partielle d'une portion d'un composant de puissance haute tension classique dans une région frontalière de celui-ci. Le composant, dont une partie seulement est illustrée, est formé dans un substrat de silicium faiblement dopé 1. Dans toute la suite de la présente description, on considérera que ce substrat est de type N mais bien entendu tous les types de conductivité pourraient être inversés. Le composant est délimité à sa périphérie par un mur d'isolement 2 de type P qui s'étend de la face supérieure à la face inférieure du substrat.

Dans une configuration courante de composants semiconducteurs verticaux haute tension, une couche 3 de type P est formée de façon continue ou non sur la face inférieure du substrat et s'étend jusqu'au mur d'isolement. Du côté de la face supérieure du substrat, on trouve une couche 4 également de type P. La couche 4 de type P, le substrat 1 de type N et la couche 3 de type P sont des couches constitutives d'un composant vertical haute tension, la haute tension pouvant être supportée notamment du fait de la forte épaisseur et du faible niveau de dopage du substrat 1. L'ensemble des couches PNP 4-1-3 pourra par exemple constituer un transistor.

Une métallisation de face arrière M1 est en contact avec l'ensemble de la face arrière du composant et une métallisation M2 est liée, directement ou indirectement, à la couche 4. Cette liaison est directe dans le cas où l'on cherche à faire un transistor PNP. Dans le cas représenté, où l'on cherche à faire un thyristor avec ou sans gâchette, une couche supplémentaire 5 fortement dopée de type N est réalisée pour constituer la cathode du thyristor en contact avec la métallisation M2. La périphérie de la couche 4 est espacée du mur d'isolement 2 par une portion du substrat 1 et comporte de préférence une zone 6 de type P faiblement dopée (P⁻) plus profonde que la région 4.

Lorsqu'une tension positive est appliquée entre les métallisations M1 et M2, la jonction bloquante est la jonction entre le substrat 1 et la région P 4-6. Autour de cette jonction, la tenue en tension est assurée par une zone dite de charge d'espace délimitée par des équipotentielles E1L et E1H, représentées en pointillés dans la figure. L'équipotentielle E1L indique la zone au potentiel bas de l'électrode M2, par exemple 0 volt. L'équipotentielle E1H désigne la zone au potentiel haut de l'électrode M1, par exemple 600 volts.

Quand le dispositif est polarisé en inverse, c'est-à-dire que la métallisation M2 est polarisée positivement par rapport à la métallisation M1, la tenue en tension est essentiellement assurée par la jonction entre le substrat 1 et d'une part la couche P 3, d'autre part le mur d'isolement 2. On a désigné par E2L et E2H les limites de la zone de charge d'espace, c'est-à-dire les équipotentielles au potentiel bas et au potentiel haut, respectivement. Pour qu'un dispositif ait une tenue en tension élevée, il convient que les équipotentielles extrêmes soient aussi écartées que possible pour ne pas atteindre le potentiel de claquage dans le semiconducteur (de l'ordre de 20 V/*µ*m). Ainsi, il convient que l'une des couches au voisinage de la jonction qui assure la tenue en tension soit relativement peu dopée pour que la zone de charge d'espace puisse s'y étendre assez largement.

Indépendamment de la nécessité d'assurer une tenue en tension suffisante du composant quand des potentiels élevés sont appliqués à ses bornes, il se pose également des problèmes de courant de fuite. Pour diverses raisons, par exemple par suite d'une pollution des oxydes, il est possible que le substrat N 1 soit fortement déplété en surface sous une couche d'isolant supérieur 7. On peut même arriver à une inversion de population dans cette région de surface. Il apparaît alors une région de canal assurant une continuité électrique entre la périphérie externe de la région P 6 et la périphérie interne du mur d'isolement 2. Pour éviter ces courants de fuite, il est connu d'utiliser une région dite d'arrêt de canal (stop-channel) constituée d'une zone 8 fortement dopée de type N (N⁺) à la surface du substrat 1 entre la périphérie externe de la région 6 et la périphérie interne du mur 2. Bien que cela n'apparaisse pas dans la vue en coupe, la zone 8 forme un anneau qui s'étend sur toute la périphérie du composant concerné. Etant donné son fort niveau de dopage, l'anneau N⁺ 8 n'est pas susceptible d'être inversé et interrompt donc tout canal d'inversion susceptible de se former à la surface du composant. Pour favoriser l'équipotentialité de l'anneau d'arrêt de canal 8 et éviter qu'il se produise une déplétion localisée, il est classique de revêtir cet anneau diffusé 10 d'une métallisation (non représentée). Pour favoriser l'étalement des équipotentielles, en polarisation inverse, il est également connu de revêtir la surface supérieure du mur d'isolement 2 d'une métallisation 9 qui s'étend partiellement vers l'intérieur au-dessus de l'isolant 7, formant ainsi une plaque de champ.

Ainsi, avec des structures périphériques du type de celle de la figure 1 dans lesquelles le composant est entouré d'un mur d'isolement, on obtient de très bonnes propriétés de tenue en tension. Toutefois, ceci implique des diffusions très longues à des températures élevées, par exemple 300 heures à 1280°C. De plus, ces diffusions, une fois réalisées, occupent une surface non négligeable qui peut même être supérieure à la surface du composant qu'elles délimitent.

On a donc cherché à réaliser des structures périphériques exemptes de mur d'isolement. Un exemple d'une telle structure est illustré en figure 2A. Du côté de la face supérieure, on retrouve sensiblement les mêmes éléments que ceux de la figure 1, à l'exception du fait qu'il n'y a pas de caisson P latéral. Une région 10 de type N⁺ est seulement formée au voisinage de la périphérie. La région 10 sera de préférence plus éloignée du bord extérieur de la région de type P 6 que l'était la région d'arrêt de canal 8 de la figure 1.

Du côté de la face inférieure, on réalise une structure sensiblement symétrique de celle de la face supérieure. Ainsi, la région 3 de type P est interrompue et est entourée d'une région 12 faiblement dopée de type P similaire à la région 6 du côté de la face supérieure. Egalement, du côté de la face inférieure, une couche isolante 13 est déposée à la périphérie du composant et la métallisation M1 est en contact avec la seule région P⁺ et s'étend légèrement au-dessus de cette région d'isolement 12. Une région de type N⁺ 14 est également formée à la périphérie du composant.

Ce type de structure, outre le fait qu'il pose des problèmes de tenue en tension plus délicats que dans le cas de la figure 1, pose un problème pour la réalisation des brasures. De façon classique, un composant vertical est entièrement brasé par sa face inférieure sur un radiateur ou répartiteur thermique par l'intermédiaire d'une pastille de brasure 20 (figure 2B). Si le répartiteur s'étend sur une surface au moins égale à la surface inférieure du composant, la brasure 20 a tendance à déborder latéralement et éventuellement à remonter sur la tranche du composant. Cette remontée est désignée par la référence 22. Cette structure a un double inconvénient. D'une part, la brasure a une fonction de plaque de champ et tend à faire s'étendre le potentiel E2H jusqu'à la région N⁺ 14 et à dégrader la tenue en tension. D'autre part, la remontée de brasure 22 constitue un court-circuit pour le composant.

Pour éviter ces problèmes, on tend à utiliser un répartiteur tel qu'illustré en figure 2C dont la face supérieure comporte un bossage 24 de surface inférieure à celle de la pastille qui est destinée à y être montée. Ainsi, la brasure 20, même si elle présente un léger débordement 26, ne jouera pas le rôle de plaque de champ tendant à étaler l'équipotentielle E2H et ne tendra pas non plus à créer un court-circuit. Cette solution donne des résultats satisfaisants mais pose des problèmes de fabrication. En effet, la dimension du bossage 24 est liée à la dimension de la puce. Il faut donc prévoir un répartiteur spécifique pour chaque dimension de puce, sans compter les difficultés de positionnement.

Une autre solution également proposée pour résoudre ce type de problème est de creuser la périphérie du composant et de remplir l'évidement d'un verre. Toutefois, la présence de verre pose des problèmes de tenue en température et rend les opérations de découpe plus délicates.

Ainsi, un objet de la présente invention est de prévoir une structure périphérique de composant de puissance permettant d'obtenir des tensions élevées.

Un autre objet de la présente invention est de prévoir une telle structure qui ne pose pas de difficultés de fabrication.

Un autre objet de la présente invention est de prévoir une telle structure qui ne soulève pas d'autres problèmes secondaires tels que ceux évoqués précédemment.

Pour atteindre ces objets, la présente invention prévoit un composant de puissance formé dans un substrat de silicium d'un premier type de conductivité, dont les faces inférieure et supérieure comprennent respectivement une première et une deuxième région du deuxième type de conductivité ne s'étendant pas jusqu'à la périphérie du composant, une tension élevée étant susceptible d'exister entre les première et deuxième régions et devant être supportée par les jonctions entre les première et deuxième régions et le substrat. Il est prévu, à la périphérie inférieure du composant, une région isolante profonde ne rejoignant pas la première région, la surface inférieure du substrat entre ladite région isolante profonde étant revêtue d'une couche isolante, la hauteur de la région isolante profonde étant supérieure à celle d'une éventuelle remontée de brasure lors de la brasure de la face inférieure sur un répartiteur thermique.

Selon un mode de réalisation de la présente invention, le composant de puissance comprend en outre une rainure large et peu profonde avant la région isolante profonde.

Selon un mode de réalisation de la présente invention, la région isolante profonde est formée en gravant d'abord des rainures rapprochées à partir de la face inférieure du substrat à la périphérie de celui-ci puis en procédant à une oxydation thermique, de sorte que les nervures entre les diverses rainures sont oxydées et que les rainures sont remplies.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1, 2A, 2B et 2C sont des vues en coupe schématiques d'une zone périphérique d'un composant haute tension selon l'art antérieur ;
la figure 3 est une vue en coupe schématique d'une zone périphérique d'un composant haute tension selon la présente invention ;
Les figures 4A et 4B représentent deux étapes successives de la formation d'une zone d'isolement selon la présente invention ; et
les figures 5A, 5B et 5C représentent des étapes successives de la formation d'une zone d'isolement selon une variante de la présente invention.

Dans les diverses figures, conformément à l'usage dans le domaine de la représentation des composants semiconducteurs, les diverses dimensions ne sont pas tracées à l'échelle et ont été arbitrairement tracées pour faciliter la lisibilité des figures et en améliorer l'intelligibilité. L'homme de l'art saura adapter les diverses épaisseurs et niveaux de dopage en fonction des règles habituelles de fabrication des composants semiconducteurs de puissance.

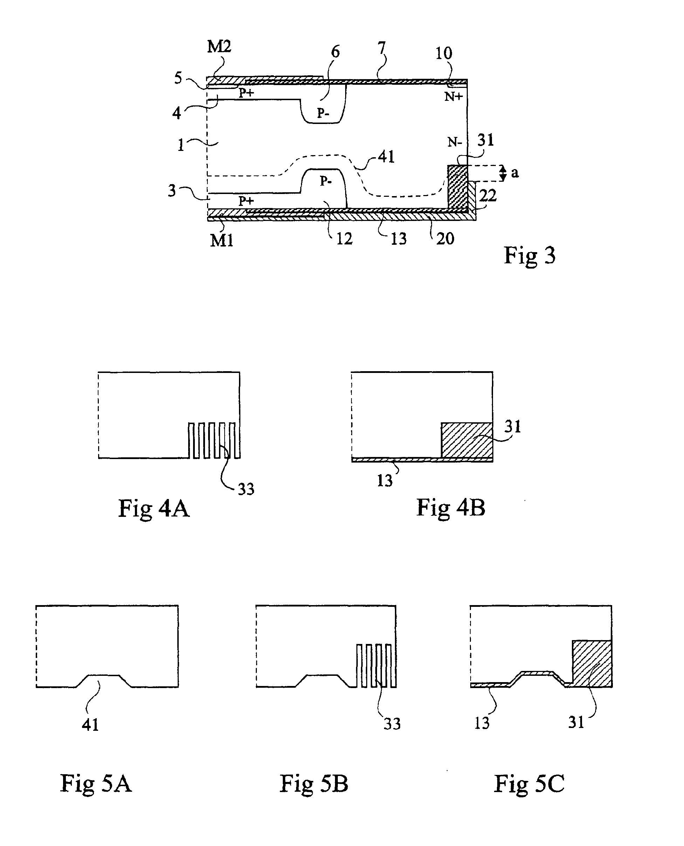

La figure 3 représente la même région périphérique d'un composant haute tension que celle représentée en figures 1 et 2. Plus particulièrement, la structure illustrée en figure 3 est semblable à celle illustrée en figure 2B. Elle a été représentée alors qu'une brasure 20 est formée du côté de la face inférieure et présente une remontée latérale 22. La structure de la présente invention est semblable à celle de la figure 2A, sauf que, à la périphérie, au lieu de prévoir une région N⁺, il est prévu une zone isolante périphérique relativement profonde 31, qui est en tout cas plus profonde d'une distance a que la distance maximum possible de la remontée de brasure pour un procédé d'assemblage donné. Alors, la région 31 ne se comporte plus comme un court-circuit mais comme un isolant situé sous une plaque de champ. Les équipotentielles, dont l'une est désignée par la référence 41, tendent donc à s'étendre jusqu'à la surface latérale du composant, ce qui est une configuration particulièrement favorable pour une tenue en tension élevée.

Les figures 4A et 4B sont des vues partielles du coin inférieur droit d'une structure, illustrant un procédé de formation de la région d'isolement profonde 31. Dans un première étape illustrée en figure 4A, on forme par tout moyen connu des rainures profondes et rapprochées dans le coin inférieur droit du substrat à partir de la face inférieure. Dans une deuxième étape on procède à une oxydation, pour oxyder les nervures demeurant entre les rainures susmentionnées, remplir ces rainures, et oxyder la face inférieure du substrat.

Selon une variante de la présente invention illustrée en figures 5A à 5C, on pourra procéder au préalable à la formation d'une rainure peu profonde 41 destinée à absorber une partie d'un excédent éventuel de brasure, avant de former les rainures 33 puis des oxydations 31 et 13. Sa rainure peu profonde 41 limite d'éventuelles remontées de brasure.

La présente invention est susceptible de diverses variantes et modifications qui apparaîtront à l'homme de l'art. Les dimensions seront choisies de façon à permettre des tenues en tension et en courant choisies.

La présente invention présente des avantages par rapport à toutes les structures périphériques décrites précédemment.

Par rapport à la structure à mur d'isolement périphérique illustrée en figure 1, elle présente l'avantage d'une plus grande simplicité de fabrication en évitant de former les murs d'isolement.

Par rapport à la structure de la figure 2, elle présente l'avantage d'une meilleure tenue en tension tout en permettant d'utiliser des supports de puces sans bossage ou épaulement.

Par rapport à une structure à périphérie creusée et glassivée, elle présente l'avantage d'une plus grande simplicité de réalisation et d'une plus grande facilité de découpe entre deux puces adjacentes. Bien que dans ce qui précède on ait décrit une puce unique, celle-ci sera fabriquée à partir d'une tranche de silicium de grande surface. Les régions d'isolement latérales 31 correspondront en fait à la séparation entre deux puces voisines et la découpe pourra se faire sans difficultés à partir d'une région d'oxyde de silicium.

## Revendications

1. Composant de puissance formé dans un substrat (1) de silicium d'un premier type de conductivité, dont les faces inférieure et supérieure comprennent respectivement une première (3) et une deuxième (4) région du deuxième type de conductivité ne s'étendant pas jusqu'à la périphérie du composant, une tension élevée étant susceptible d'exister entre les première et deuxième régions et devant être supportée par les jonctions entre les première et deuxième régions et le substrat,
**caractérisé en ce qu'**il comprend, à la périphérie inférieure du composant une région isolante profonde (31) ne rejoignant pas la première région (3), la surface inférieure du substrat entre ladite région isolante profonde et la première région étant revêtue d'une couche isolante (13), la hauteur de la région isolante profonde étant supérieure à celle d'une éventuelle remontée de brasure (22) lors de la brasure de la face inférieure sur un répartiteur thermique.

2. Composant de puissance selon la revendication 1, **caractérisé en ce qu'**il comprend en outre une rainure large et peu profonde (41) avant la région isolante profonde (31).

3. Procédé de fabrication d'un composant de puissance selon la revendication 1, dans lequel la région isolante profonde (31) est formée en gravant d'abord des rainures rapprochées à partir de la face inférieure du substrat à la périphérie de celui-ci puis en procédant à une oxydation thermique, de sorte que les nervures entre les diverses rainures sont oxydées et que les rainures sont remplies.
